(19) Europäisches Patentamt / European Patent Office / Office européen des brevets

(11) EP 4 726 414 A1

(12) **EUROPEAN PATENT APPLICATION**
published in accordance with Art. 153(4) EPC

(43) Date of publication:
15.04.2026 Bulletin 2026/16

(21) Application number: 24818981.3

(22) Date of filing: 05.03.2024

(51) International Patent Classification (IPC):
*G01R 31/392* (2019.01)    *G01R 31/367* (2019.01)
*G01R 31/382* (2019.01)    *G01R 31/389* (2019.01)
*H01M 10/48* (2006.01)

(52) Cooperative Patent Classification (CPC):
Y02E 60/10

(86) International application number:
PCT/JP2024/008352

(87) International publication number:
WO 2024/252742 (12.12.2024 Gazette 2024/50)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 08.06.2023 JP 2023094679

(71) Applicant: Hitachi, Ltd.
Tokyo 100-8280 (JP)

(72) Inventors:
• KONISHI Hiroaki
  Tokyo 100-8280 (JP)
• KAWAJI Jun
  Tokyo 100-8280 (JP)
• HARA Takaaki
  Tokyo 100-8280 (JP)
• NISHIHARA Atsuo
  Tokyo 100-8280 (JP)

(74) Representative: MERH-IP Matias Erny Reichl Hoffmann
Patentanwälte PartG mbB
Paul-Heyse-Straße 29
80336 München (DE)

(54) **SECONDARY BATTERY DETERIORATION PREDICTION SYSTEM AND SECONDARY BATTERY DETERIORATION PREDICTION METHOD**

(57) Provided is a secondary battery deterioration prediction system including: an acquisition unit that acquires, in each operation condition, a relationship between a charging status and an open circuit voltage of a secondary battery and a relationship between the charging status and an internal resistance of the battery; an internal state diagnosis unit that diagnoses, based on the acquired relationships, a deterioration state of a positive electrode and a negative electrode of the secondary battery in each operation condition; a life prediction formula generation unit that generates a life prediction formula based on a time series change in the obtained deterioration state; and a deterioration calculation unit that calculates deterioration of the secondary battery based on the life prediction formula. The life prediction formula generation unit generates a life prediction formula based on a time series change in a deterioration state of the positive electrode and the negative electrode in a case where a load is applied to the secondary battery.

[FIG. 2]

FIG. 2

## Description

Technical Field

The present invention relates to a secondary battery deterioration prediction system and a secondary battery deterioration prediction method.

Background Art

In order to reduce the emission of carbon dioxide, it is necessary to replace energy derived from thermal power generation, which is currently mainly used as a supply source for energy demand, with renewable energy such as solar power generation or wind power generation. However, when thermal power generators are disconnected from systems, the adjustable capacity supply capability for system stability decreases with respect to fluctuations in demand. On the other hand, individual renewable energy generators may be equipped with battery energy storage systems (BESS) using secondary batteries for mitigating fluctuations in power generation values of the renewable energy generators. When capacities of the batteries can be utilized as adjustable capacities, the capacities can contribute to system stability.

The battery energy storage systems decrease in performance due to deterioration of the secondary batteries in operation processes thereof.

Hence, in a case where the battery energy storage systems are introduced for an aim of operating the systems for a predetermined period, it is necessary to prepare a design in anticipation of deterioration of the secondary batteries. However, when the accuracy of secondary battery deterioration prediction is low, it is necessary to prepare a design with a large safety margin, and thus costs of the battery energy storage systems increase due to excessive battery mounting. Hence, there is a demand for a deterioration prediction system that predicts a life of a battery with high accuracy.

PTL 1 describes a secondary battery internal information detection method. In the detection method described in PTL 1, a charge-discharge curve of a positive electrode and a charge-discharge curve of a negative electrode are superimposed and calculated to reproduce a charge-discharge curve of a secondary battery, and a deterioration state of the positive electrode or the negative electrode is evaluated in a non-destructive manner.

Citation List

Patent Literature

PTL 1: JP 2009-080093 A

Summary of Invention

Technical Problem

As described above, in the method described in PTL 1, the charge-discharge curve of the secondary battery is reproduced based on the charge-discharge curves of the positive electrode and the negative electrode. Moreover, in a charge-discharge curve reproduction process, amounts of effective active materials of the positive electrode and the negative electrode, an index of a positional relationship between the charge-discharge curves of the positive electrode and the negative electrode, and open circuit potentials of the positive electrode and the negative electrode are obtained.

Even by the conventional method described in PTL 1, it is possible to perform, with high accuracy, diagnosis of a battery system including a $LiNi_xMn_yCO_zM_{1-x-y-z}O_2$ positive electrode (M: arbitrary element), a $LiMn_2O_4$ positive electrode, graphite, a Si negative electrode, a SiO negative electrode, or the like which is an electrode active material system in which a voltage changes due to a change in charging status.

However, it is difficult to diagnose a battery system including a $LiFePO_4$ positive electrode, a $Li_4Ti_5O_{12}$ negative electrode, or the like, which is an electrode active material system in which a change in voltage due to a change in charging status is small.

In this respect, an object of the present invention is to provide a secondary battery deterioration prediction system and a secondary battery deterioration prediction method capable of diagnosing, with high accuracy, an internal state of a secondary battery including an electrode active material having a small voltage change due to a change in charging status.

Solution to Problem

In order to solve the above-described problems, for example, configurations to be described in CLAIMS are employed.

The present application includes a plurality of means for solving the above problems, and an example thereof is a secondary battery deterioration prediction system including: an acquisition unit that acquires, in each operation condition of a secondary battery, a relationship between a charging status and an open circuit voltage of the secondary battery and a relationship between the charging status and an internal resistance of the battery; an internal state diagnosis unit that diagnoses, based on the relationships acquired by the acquisition unit, deterioration states of a positive electrode and a negative electrode of the secondary battery in each operation condition; a life prediction formula generation unit that generates a life prediction formula for predicting a life of the secondary battery based on time series changes in the deterioration states obtained by the internal state diagnosis unit; and a deterioration calculation unit that calculates deterioration of the secondary battery based on the life prediction formula generated by the life prediction formula generation unit.

Here, the life prediction formula generation unit is configured to generate a life prediction formula based on time series changes in deterioration states of the positive electrode and the negative electrode in a case where a load is applied to the secondary battery.

Advantageous Effects of Invention

According to the present invention, even in a secondary battery system having a small change in voltage with respect to a change in charging status, an internal state of a secondary battery can be diagnosed with high accuracy, and a life thereof can be predicted with high accuracy based on the obtained diagnosis result.

Problems, configurations, and effects other than those described above will be clarified by the following description of embodiments.

Brief Description of Drawings

[FIG. 1] FIG. 1 is a block diagram illustrating a configuration example of a secondary battery deterioration prediction system according to an embodiment of the present invention.

[FIG. 2] FIG. 2 is a block diagram illustrating a configuration example of a function that is performed by a calculator of the secondary battery deterioration prediction system according to the embodiment of the present invention.

[FIG. 3] FIG. 3 is a graph illustrating examples of internal state diagnosis (a battery voltage, a positive electrode potential, and a negative electrode potential) of a secondary battery according to the embodiment of the present invention.

[FIG. 4] FIG. 4 is a graph illustrating examples of internal state diagnosis (a battery resistance, a positive electrode resistance, and a negative electrode resistance) of the secondary battery according to the embodiment of the present invention.

[FIG. 5] FIG. 5 is a graph illustrating examples of a time series change in a deterioration parameter (an active material utilization of a positive electrode and an active material utilization of a negative electrode) of the secondary battery according to the embodiment of the present invention.

[FIG. 6] FIG. 6 is a graph illustrating examples of a time series change in a deterioration parameter (a lithium ion loss associated with film formation on a positive electrode surface and a lithium ion loss associated with film formation on a negative electrode surface) of the secondary battery according to the embodiment of the present invention.

[FIG. 7] FIG. 7 is a flowchart illustrating a processing example of secondary battery life prediction according to the embodiment of the present invention.

Description of Embodiments

Hereinafter, a secondary battery deterioration prediction system and a secondary battery deterioration prediction method according to an embodiment (hereinafter referred to as the "present example") of the present invention will be described with reference to the accompanying drawings.

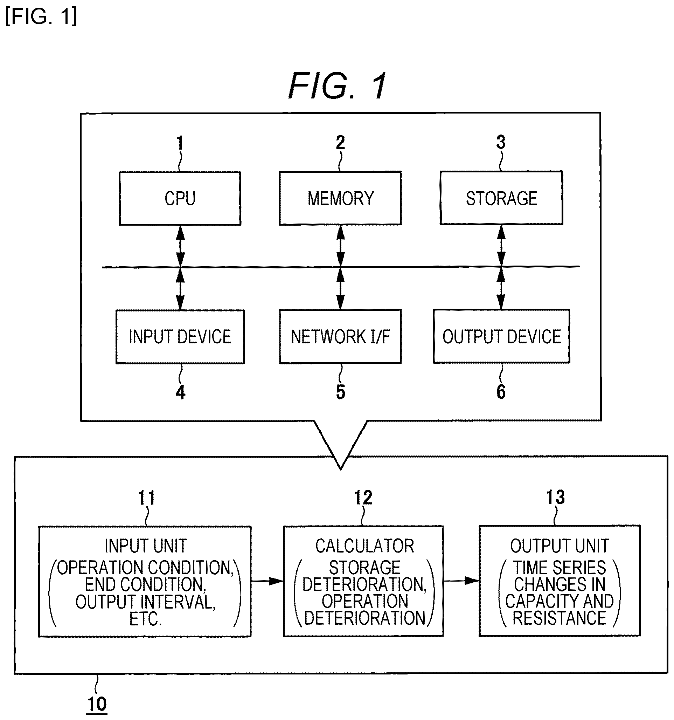

FIG. 1 illustrates a configuration example of a secondary battery deterioration prediction system 10 of the present example. The secondary battery deterioration prediction system 10 of the present example includes an input unit 11, a calculator 12, and an output unit 13.

A secondary battery operation condition, a calculation end condition, an output interval, and the like are input as input factors for performing secondary battery deterioration prediction to the input unit 11. Examples of the operation condition of the secondary battery include a temperature, and a load (current). Examples of the calculation end condition include a period (such as ten years) and a decrease in battery capacity to 70% or lower. Examples of the output interval include output of a calculation result every ten days.

These input factors are input by, for example, an operator who performs the deterioration prediction.

The calculator 12 performs a calculation process regarding a capacity and a resistance of the secondary battery until an end condition input to the input unit 11 is satisfied.

The output unit 13 outputs, as values of the output intervals in the period (such as every ten days) input to the input unit 11, calculation results of the capacity and the resistance of the secondary battery obtained by the calculation in the calculator 12.

The secondary battery deterioration prediction system 10 illustrated in FIG. 1 includes, for example, a computer. That is, as illustrated in FIG. 1, the secondary battery deterioration prediction system 10 including a computer device includes a central processing unit (CPU) 1, a memory 2, a storage 3, an input device 4, a network interface 5, and an output unit 6 which are individually connected to a bus.

The CPU 1 is an arithmetic processing unit that reads, from the memory 2 or the storage 3, a program code of software that implements a function performed by the secondary battery deterioration prediction system 10 and executes the program code.

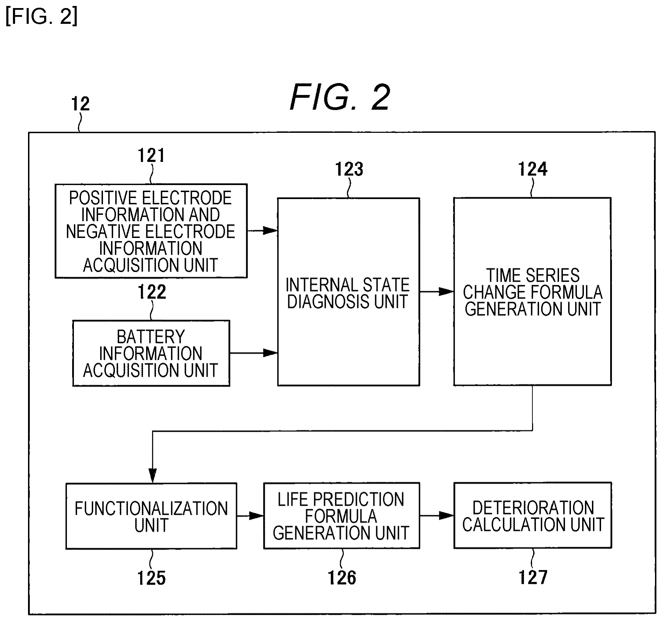

The CPU 1 reads the program code from the memory 2 or the storage 3 and executes arithmetic processing in a work area of the memory 2, thereby configuring, in the memory 2, various processing function units illustrated in FIG. 2 to be described below.

As the storage 3, for example, a large capacity information storage medium such as a hard disk drive (HDD), a solid state drive (SSD), or a memory card is used. The storage 3 stores software that implements functions of the secondary battery deterioration prediction system 10 and data obtained by executing a program of the software.

As the input device 4, equipment such as a keyboard or a mouse is used, and an input process of various items of information is performed based on operation of the operator.

For example, as the network interface 5, a network interface card (NIC) or the like is used, and reception of a program or the like from the outside, transmission of a processing result, or the like is performed.

As the output unit 6, output equipment such as a display or a printer is used, and an output process such as display or printing of a calculation result is performed.

Note that the secondary battery deterioration prediction system 10 including the computer illustrated in FIG. 1 is described as an example, and the secondary battery deterioration prediction system 10 may include another arithmetic processing device instead of the computer. For example, some or all of the functions performed by the secondary battery deterioration prediction system 10 may be implemented by hardware such as a field programmable gate array (FPGA) or an application specific integrated circuit (ASIC).

FIG. 2 illustrates processing units constituting the calculator 12 of the secondary battery deterioration prediction system 10 of the present example.

The calculator 12 includes a positive electrode information and negative electrode information acquisition unit 121, a battery information acquisition unit 122, an internal state diagnosis unit 123, a time series change formula generation unit 124, a functionalization unit 125, a life prediction formula generation unit 126, and a deterioration calculation unit 127. These processing units 121 to 127 are individually configured in the memory 2 illustrated in FIG. 1 by executing software that implements the functions performed by the secondary battery deterioration prediction system 10.

However, regarding the positive electrode information and negative electrode information acquisition unit 121 and the battery information acquisition unit 122, information measured using other equipment separate from the secondary battery deterioration prediction system 10 may be acquired.

Examples of calculations performed by the calculator 12 include a life prediction calculation reflecting storage deterioration of the secondary battery and a life prediction calculation reflecting operation deterioration of the secondary battery. First, an example in which the calculator 12 performs the life prediction calculation reflecting storage deterioration of the secondary battery will be described.

The positive electrode information and negative electrode information acquisition unit 121 performs an acquiring process of acquiring information of open circuit potentials (OCP) and resistances of a positive electrode and a negative electrode, the information being necessary to diagnose an internal state of the battery.

An example of an information acquisition method in the positive electrode information and negative electrode information acquisition unit 121 will be described below.

First, a positive electrode monopole cell using a positive electrode and a lithium metal, and a negative electrode monopole cell using a negative electrode and a lithium metal, which are used in the secondary battery of a life prediction target, are prepared. Subsequently, the galvanostatic intermittent titration technique (GITT) is performed on the monopole cells to acquire information of the open circuit potential and the resistance.

In the galvanostatic intermittent titration technique, a cycle of fully charging the monopole cell, then discharging the monopole cell at a current equivalent to 1 C[A] for 72 seconds, and taking a pause for 30 minutes is repeated until a discharge cutoff potential is reached. As an open circuit potential at each state of charge (SOC), a potential obtained in 30 minutes' time after a discharge current is stopped is used. In addition, a resistance at each state of charge (SOC) is calculated by dividing, by the discharge current, a difference between an open circuit potential before the start of discharge and an open circuit potential when a predetermined discharge time elapses.

The battery information acquisition unit 122 performs an acquiring process of acquiring information of a secondary battery open circuit voltage (OCV) and a resistance, the information being necessary for the internal state diagnosis unit 123 to diagnose the internal state of the battery.

An example of an information acquisition method in the battery information acquisition unit 122 will be described below.

First, the secondary battery is subjected to a storage test in which the secondary battery is stored at a predetermined temperature and a state of charge (SOC) for a certain period of time.

When the storage test is conducted, the battery information acquisition unit 122 periodically stops the test, implements the galvanostatic intermittent titration technique, and acquires information of the open circuit voltage and the resistance.

In the galvanostatic intermittent titration technique, a cycle of fully charging the monopole cell, then discharging the monopole cell at a current equivalent to 1 C[A] for 72 seconds, and taking a pause for 30 minutes is repeated until the discharge cutoff potential is reached. As an open circuit potential at each state of charge (SOC), a potential obtained in 30 minutes' time after a discharge current is stopped is used. In addition, a resistance at each state of charge (SOC) is calculated by dividing, by the discharge current, a difference between an open circuit voltage before the start of discharge and an open circuit voltage when a predetermined discharge time elapses.

The internal state diagnosis unit 123 performs an internal state diagnosing process of diagnosing the internal state of the secondary battery using the items of information obtained by the positive electrode information and negative electrode information acquisition unit 121 and the battery information acquisition unit 122.

That is, the internal state diagnosis unit 123 diagnoses the internal state of the secondary battery by comparing data of the open circuit potentials and the resistances of the positive electrode and the negative electrode obtained by the positive electrode information and negative electrode information acquisition unit 121 with data of the open circuit voltage and the resistance of the secondary battery obtained by the battery information acquisition unit 122.

Examples of a diagnosis target for the internal state include an active material utilization $m_p$ of the positive electrode, an active material utilization $m_n$ of the negative electrode, a lithium ion loss $\delta_p$ associated with film formation on a positive electrode surface, a lithium ion loss $\delta_n$ associated with film formation on a negative electrode surface, a solution resistance $R_0$ of the battery, a resistance increase rate $a_p$ of the positive electrode, and a resistance increase rate $a_n$ of the negative electrode, which are correlated with the battery deterioration.

Here, the active material utilization $m_p$ of the positive electrode is an index indicating a ratio of an active material capable of contributing to a battery reaction, among positive electrode active materials contained in an electrode.

The active material utilization $m_n$ of the negative electrode is an index indicating a ratio of an active material capable of contributing to the battery reaction, among negative electrode active materials contained in the electrode.

The lithium ion loss $\delta_p$ associated with film formation on a positive electrode surface is an index indicating a quantity of electricity of lithium ions trapped in a film formed by a reaction with an electrolyte on the positive electrode surface.

The lithium ion loss $\delta_n$ associated with film formation on a negative electrode surface is an index indicating a quantity of electricity of lithium ions trapped in the film formed by a reaction with the electrolyte on the negative electrode surface.

The solution resistance $R_0$ of the battery is an index indicating a resistance of a battery member when the battery is used.

The resistance increase rate $a_p$ of the positive electrode is an index indicating a resistance increase rate of the positive electrode when the battery is used.

The resistance increase rate $a_n$ of the negative electrode is an index indicating a resistance increase rate of the negative electrode when the battery is used.

These seven indexes are set as variable parameters, and the data of the open circuit potentials and resistances of the positive electrode and the negative electrode obtained by the positive electrode information and negative electrode information acquisition unit 121 are fitted to the data of the open circuit voltage and the resistance of the secondary battery obtained by the battery information acquisition unit 122.

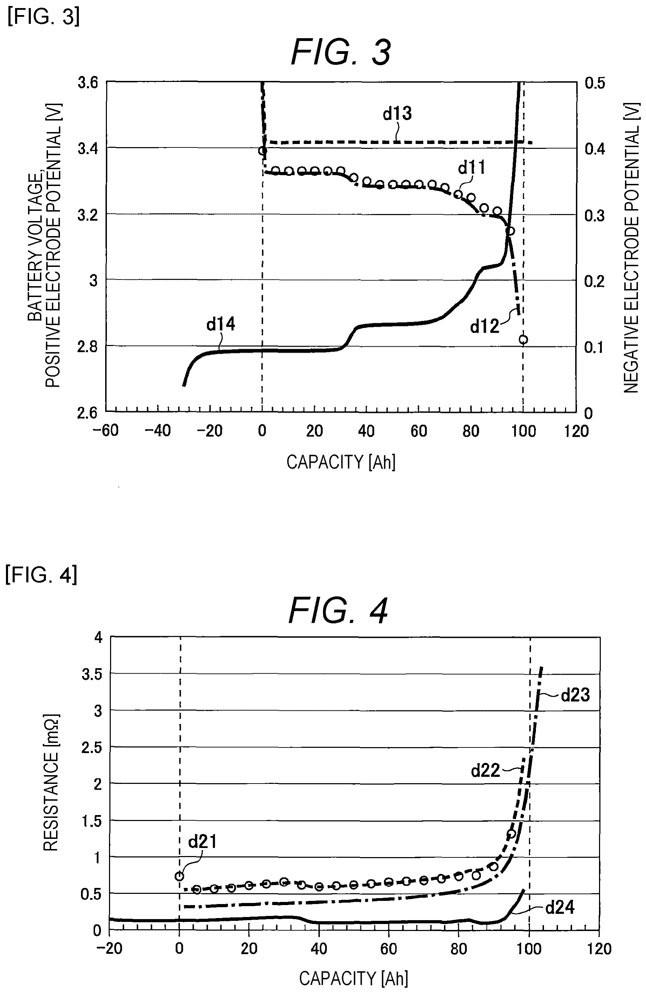

FIGS. 3 and 4 are graphs illustrating an example of a fitting result.

FIG. 3 illustrates a measured value d11 of the open circuit voltage (OCV) of the secondary battery, a calculated value d12 thereof, a positive electrode potential (calculated value) d13, and a negative electrode potential (calculated value) d14. In FIG. 3, the left axis of ordinate represents a battery voltage and a positive electrode potential [V], and the right axis of ordinate represents a negative electrode potential [V]. The axis of abscissa represents a battery capacity [Ah].

In FIG. 3, the measured values d11 of the open circuit voltage of the secondary battery are locations plotted by white circles, and the calculated value d12 is a value calculated based on the measured values d11.

FIG. 4 illustrates measured values d21 of the resistance of the secondary battery, a calculated value d22 thereof, a positive electrode resistance (calculated value) d23, and a negative electrode resistance (calculated value) d24. In FIG. 4, the axis of ordinate represents a resistance [mΩ], and the axis of abscissa represents a battery capacity [Ah].

In FIG. 4, the measured values d21 of the resistance of the secondary battery are locations plotted by white circles, and the calculated value d22 is a value calculated based on the measured values.

Here, a calculation formula to obtain these values is described as follows. First, when a positive electrode capacity is represented by $q_p$ and a negative electrode capacity is represented by $q_n$, a capacity $Q_c$ of the secondary battery can be described by the following formula.

$$Q_c = m_p \times q_p - \delta_p = m_n \times q_n - \delta_n$$

Next, an open circuit voltage $V_c$ at each capacity (charging status) of the secondary battery can be described by the following formula using open circuit potentials ($V_p$ and $V_n$) of the positive electrode and the negative electrode.

$$V_c(Q_c) = V_p(q_p) - V_n(q_n)$$

Further, when a positive electrode resistance is represented by $r_p$ and a negative electrode resistance is represented by $r_n$, a resistance $R_c$ at each capacity (each charging status) of the secondary battery can be described by the following formula.

$$R_c(Q_c) = a_p/m_p \times r_p(q_p) + a_n/m_n \times r_n(q_n) + R_0$$

Returning to the description of FIG. 2, the time series change formula generation unit 124 generates a time series change formula of an internal parameter obtained by the internal state diagnosis unit 123.

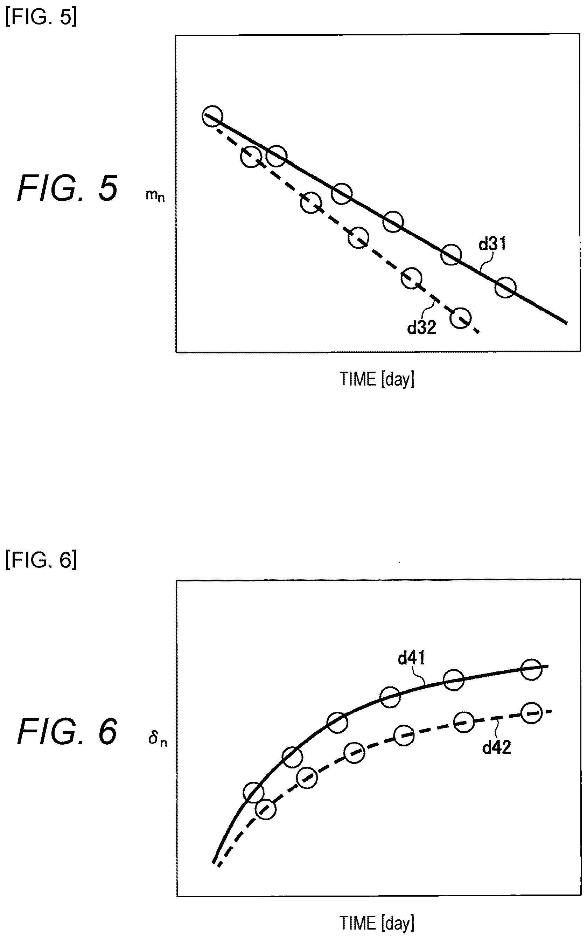

FIG. 5 illustrates an example of a time series change d31 of the active material utilization $m_n$ of the negative electrode and a time series change d32 of the active material utilization $m_p$ of the positive electrode. In FIG. 5, the axis of abscissa represents a time, and the axis of ordinate represents the active material utilization of the negative electrode.

FIG. 6 illustrates an example of a time series change d41 of the lithium ion loss $\delta_n$ associated with the film formation on the negative electrode surface and a time series change d42 of the lithium ion loss $\delta_p$ associated with the film formation on the positive electrode surface.

In FIG. 6, the axis of abscissa represents a time, and the axis of ordinate represents a lithium ion loss associated with the film formation on the negative electrode surface.

The curves illustrated in FIGS. 5 and 6 are approximate curves of time series changes of respective parameters. A shape of the approximate curve can be arbitrarily set for each parameter such as a linear curve, a quadratic curve, a root system formula, or a power system formula.

In this manner, the time series change formula generation unit 124 generates a time series change formula indicating the time series change in the internal parameter obtained by the internal state diagnosis unit 123.

For example, the time series change formula generation unit 124 generates the following formula as the time series change formula of the active material utilization $m_n$ of the negative electrode illustrated in FIG. 5.

$$m_n = m_0 - m_1 \times t$$

In addition, the time series change formula generation unit 124 generates the following formula as the time series change formula of the lithium ion loss $\delta_n$ associated with the film formation on the negative electrode surface illustrated in FIG. 6.

$$\delta_n = m_{0'} + m_{1'} \times (t)^{0.5}$$

Next, the functionalization unit 125 functionalizes coefficients of the time series change formula of individual deterioration parameters obtained by the time series change formula generation unit 124 into a function of operation conditions.

Here, an example of functionalization is described as follows. The functionalization unit 125 functionalizes dependence of coefficients $m_1$ and $m_{1'}$ on the operation conditions with respect to the following time series change formulas of the active material utilization $m_n$ of the negative electrode and the lithium ion loss $\delta_n$ associated with the film formation on the negative electrode surface illustrated in FIG. 5.

$$m_n = m_0 - m_1 \times t$$

$$\delta_n = m_{0'} + m_{1'} \times (t)^{0.5}$$

Examples of the function include the following formulas.

$$m_1 (m_{1'}) = \alpha + \beta \times \text{temperature} + \gamma \times \text{SOC}$$

$$m_1 (m_{1'}) = \alpha \times (\beta \times \text{temperature}) + (\gamma \times \text{SOC})$$

Here, $\alpha$, $\beta$, and $\gamma$ are coefficients. Values of these coefficients $\alpha$, $\beta$, and $\gamma$ are determined by performing the fitting.

A case where the calculator 12 calculates storage deterioration of the secondary battery has been described.

Next, a case where the calculator 12 calculates operation deterioration of the secondary battery will be described.

First, the positive electrode information and negative electrode information acquisition unit 121 acquires the information of the open circuit potentials and the resistances of the positive electrode and the negative electrode, the information being necessary to diagnose the internal state of the battery. The acquisition method here is similar to the case of calculating the storage deterioration.

Next, the battery information acquisition unit 122 acquires information of the secondary battery open circuit voltage and the resistance, the information being necessary to diagnose the internal state of the battery.

Here, the battery information acquisition unit 122 first performs, on the secondary battery, a cycle test of repeating charging and discharging at a constant current in a range of a predetermined state of charge (SOC) at a predetermined temperature.

Moreover, when the cycle test is conducted, the battery information acquisition unit 122 periodically stops the test, implements the galvanostatic intermittent titration technique (GITT), and acquires information of the open circuit voltage and the resistance.

In the galvanostatic intermittent titration technique, a cycle of fully charging the monopole cell, then discharging the monopole cell at a current equivalent to 1 C[A] for 72 seconds, and taking a pause for 30 minutes is repeated until the discharge cutoff potential is reached. As an open circuit potential at each state of charge (SOC), a potential obtained in 30 minutes' time after a discharge current is stopped is used. In addition, a resistance at each state of charge (SOC) is calculated by dividing, by the discharge current, a difference between an open circuit voltage before the start of discharge and an open circuit voltage when a predetermined discharge time elapses.

Moreover, the internal state diagnosis unit 123 diagnoses the internal state of the secondary battery using the items of information obtained by the positive electrode information and negative electrode information acquisition unit 121 and the battery information acquisition unit 122.

That is, the internal state diagnosis unit 123 diagnoses the internal state of the secondary battery by comparing the data of the open circuit potentials and the resistances of the positive electrode and the negative electrode obtained by the positive electrode information and negative electrode information acquisition unit 121 with the data of the open circuit voltage and the resistance of the secondary battery obtained by the battery information acquisition unit 122.

Note that examples of a diagnosis target for the internal state include an active material utilization $m_p$ of the positive electrode, an active material utilization $m_n$ of the negative electrode, a lithium ion loss $\delta_p$ associated with film formation on a positive electrode surface, a lithium ion loss $\delta_n$ associated with film formation on a negative electrode surface, a solution resistance $R_0$ of the battery, a resistance increase rate $a_p$ of the positive electrode, and a resistance increase rate $a_n$ of the negative electrode, which are correlated with the battery deterioration.

The internal state diagnosis unit 123 sets these seven indexes as variable parameters and performs fitting of the data of the open circuit potentials and resistances of the positive electrode and the negative electrode obtained by the positive electrode information and negative electrode information acquisition unit 121 to the data of the open circuit voltage and the resistance of the secondary battery obtained by the battery information acquisition unit 122. A fitting method is similar to the case of calculating the storage deterioration of the secondary battery.

Further, the time series change formula generation unit 124 generates the time series change formula of the internal parameter obtained by the internal state diagnosis unit 123.

Here, since an internal parameter of an operation load includes an effect of the storage load, the time series change formula generation unit 124 calculates a change in the internal parameter of only the operation load by subtracting a change in a parameter due to a storage load calculated by a function of individual parameters of the storage load obtained at the time of calculating the storage deterioration.

Subsequently, the time series change formula generation unit 124 plots the time series changes of the individual parameters and draws an approximate curve. The shape of the approximate curve can be arbitrarily set for each parameter such as a linear curve, a quadratic curve, a root system formula, or a power system formula.

Moreover, the functionalization unit 125 functionalizes coefficients of the obtained time series change formula of the individual deterioration parameters by a function of operation conditions.

As an example of functionalization, the functionalization unit 125 functionalizes dependence of coefficients $m_1$ and $m_{1'}$ on the operation conditions with respect to the following time series change formulas of the active material utilization $m_n$ of the negative electrode and the lithium ion loss $\delta_n$ associated with the film formation on the negative electrode surface.

$$m_n = m_0 - m_1 \times t$$

$$\delta_n = m_{0'} + m_{1'} \times (t)^{0.5}$$

Examples of the function include the following formulas.

$$m_1 (m_{1'}) = \alpha + \beta \times temperature + \gamma \times center\ SOC + \varepsilon \times SOC\ range + \zeta \times current$$

$$m_1 (m_{1'}) = \alpha \times (\beta \times temperature) \times (\gamma \times center\ SOC) \times (\varepsilon \times SOC\ range) \times (\zeta \times current).$$

Here, $\alpha$, $\beta$, $\gamma$, $\varepsilon$, and $\zeta$ are coefficients. Values of these coefficients $\alpha$, $\beta$, $\gamma$, $\varepsilon$, and $\zeta$ are determined by performing fitting.

Moreover, the life prediction formula generation unit 126 inputs the operation condition of the secondary battery whose life is desired to be predicted into the function generated by the functionalization unit 125 at the time of calculating the storage deterioration of the secondary battery and the function generated by the functionalization unit 125 at the time of calculating the operation deterioration of the secondary battery, and generates a life prediction formula of the secondary battery whose life is desired to be predicted.

The deterioration calculation unit 127 calculates an internal deterioration parameter based on the life prediction formula generated by the life prediction formula generation unit 126.

An example in which the life prediction formula generation unit 126 generates the life prediction formula is described as follows. The life prediction formula generation unit 126 inputs the internal deterioration parameter into the following formula and generates the life prediction formula for calculating the capacity $Q_c$ and the resistance $R_c$.

$$Q_c = m_p \times q_p - \delta_p = m_n \times q_n - \delta_n$$

$$R_c = a_p/m_p \times r_p + a_n/m_n \times r_n + R_0$$

Subsequently, the deterioration calculation unit 127 calculates change rates of the capacity and the resistance by dividing a result of the life prediction formula obtained by the life prediction formula generation unit 126 by an initial capacity $Q_{ini}$ and an initial resistance $R_{ini}$ of the secondary battery.

Consequently, the deterioration calculation unit 127 can obtain time series changes in the change rates of the capacity and the resistance as illustrated in FIGS. 5 and 6. Specifically, the change rates can be described as the following formulas.

$$Change\ rate\ of\ capacity\ SOHQ = Q_c/Q_{ini} \times 100$$

$$Change\ rate\ of\ resistance\ SOHR = R_c/R_{ini} \times 100$$

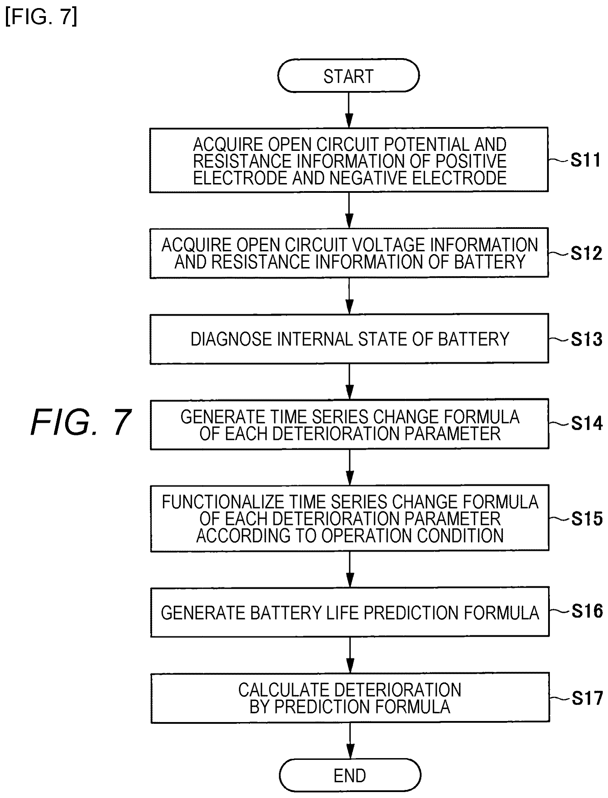

FIG. 7 is a flowchart illustrating a calculation process of the storage deterioration and a calculation process of operation deterioration of the secondary battery in the calculator 12 described above.

First, the positive electrode information and negative electrode information acquisition unit 121 acquires the information of the open circuit potentials and the resistances of the positive electrode and the negative electrode, the information being necessary to diagnose the internal state of the battery (step S11).

In addition, the battery information acquisition unit 122 acquires information of the secondary battery open circuit voltage and the resistance, the information being necessary to diagnose the internal state of the battery (step S12).

Moreover, the internal state diagnosis unit 123 diagnoses the internal state of the secondary battery using the information of the open circuit potentials and the resistances of the positive electrode and the negative electrode obtained by the positive electrode information and negative electrode information acquisition unit 121 in step S11 and the information of the secondary battery open circuit voltage and the resistance obtained by the battery information acquisition unit 122 in step S12 (step S13).

Based on the diagnosis of the internal state, the time series change formula generation unit 124 generates a time series change formula of the storage deterioration of the secondary battery and a time series change formula of the operation deterioration of the secondary battery (step S14).

Further, the functionalization unit 125 functionalizes the time series change formula of the storage deterioration of the secondary battery by the function of the operation condition and functionalizes the time series change formula of the operation deterioration of the secondary battery by the function of the operation condition (step S15).

Moreover, when the functionalization unit 125 performs the functionalization, the life prediction formula generation unit 126 inputs the operation condition of the secondary battery whose life is desired to be predicted into the function generated at the time of calculating the storage deterioration of the secondary battery and the function generated at the time of calculating the operation deterioration of the secondary battery, and performs a life prediction formula generating process of generating the life prediction formula of the secondary battery whose life is desired to be predicted (step S16).

Then, the deterioration calculation unit 127 calculates the internal deterioration parameter based on the life prediction formula generated by the life prediction formula generation unit 126 (step S17). As the internal deterioration parameter is calculated in step S17, the deterioration calculation unit 127 may calculate a deterioration state by acquiring the operation condition of the secondary battery, for example. Note that the calculated internal deterioration parameter is output in, for example, a graph of the deterioration state or a table of the deterioration state as illustrated in FIGS. 5 and 6.

As described above, according to the secondary battery deterioration prediction system 10 of the present example, even in a secondary battery system having a small change in voltage with respect to a change in charging status, the internal state of the secondary battery can be diagnosed with high accuracy, and the life thereof can be predicted with high accuracy based on the obtained diagnosis result.

Here, the internal state diagnosis unit 123 is configured to diagnose the deterioration states of the positive electrode and the negative electrode using a relationship group between the charging statuses and the open circuit potentials and a relationship group between the charging statuses and the internal resistances unique to the positive electrode active material of the secondary battery, and a relationship group between charging statuses and open circuit potentials and a relationship group between the charging statuses and internal resistances unique to the negative electrode active material of the secondary battery. Also in this respect, the internal state diagnosis unit 123 can be described to contribute to high accuracy of the life prediction.

Further, the secondary battery deterioration prediction system 10 of the present example includes the time series change formula generation unit 124 that generates the time series change formula of the state diagnosed by the internal state diagnosis unit 123, and the life prediction formula generation unit 126 is configured to generate the life prediction formula based on the time series change formula generated by the time series change formula generation unit 124. Consequently, the appropriate life prediction reflecting the time series change can be executed.

In addition, the internal state diagnosis unit 123 is configured to diagnose, when the deterioration state of the positive electrode and the negative electrode is diagnosed, the internal state by extracting the parameters of the active material utilization of the positive electrode, the active material utilization of the negative electrode, the lithium ion loss associated with the film formation on the positive electrode surface, the lithium ion loss associated with the film formation on the negative electrode surface, the solution resistance of the battery, the resistance increase rate of the positive electrode, and the resistance increase rate of the negative electrode. Also in this respect, the internal state diagnosis unit 123 may be described to contribute to high accuracy of the life prediction. Note that the case where all of these parameters are extracted and used for the diagnosis of the internal state is described as an example in the above-described embodiment, and some (at least one) of these parameters may be extracted and used for the diagnosis of the internal state.

Further, the time series change formula generation unit 124 is configured to generate a battery life prediction formula based on the time series changes in the parameter extracted extracted by the internal state diagnosis unit 123. In this respect, the time series change formula generation unit 124 contributes to the high accuracy of the life prediction.

Further, the internal state diagnosis unit 123 is configured to diagnose the deterioration of the secondary battery due to the storage load and the deterioration of the secondary battery due to the operation load, and the life prediction formula generation unit 126 is configured to generate the battery life prediction formula by combining the deterioration due to the storage load and the deterioration due to the operation load. This means that the appropriate life prediction reflecting the time series change by the deterioration due to the storage and operation loads can be executed.

Further, since the deterioration calculation unit 127 acquires the operation conditions of the secondary battery and calculates and outputs the time series changes in the capacity and the resistance of the secondary battery, the appropriate life prediction based on the operation conditions of the secondary battery can be executed.

Note that the above-described embodiment has been described in detail in order to describe the present invention in an easy-to-understand manner and is not necessarily limited to the embodiment having all the described configurations. That is, the present invention is not limited to the embodiment described above, and various modification examples and application examples are also included in the scope of the technical concept of the present invention.

For example, in the embodiment described above, the life prediction formula generation unit 126 is configured to generate the life prediction formula by calculating both the time series change in the deterioration state of the positive electrode and the negative electrode with respect to the storage deterioration in the case where no load is applied to the secondary battery and the time series change in the deterioration state of the positive electrode and the negative electrode with respect to the operation deterioration in the case where a load is applied to the secondary battery.

In contrast, the life prediction formula generation unit 126 may be configured to generate a life prediction formula based on the time series change in the deterioration state of the positive electrode and the negative electrode with respect to the operation deterioration in the case where a load is applied to the secondary battery. However, as the accuracy of life prediction, it is better to generate a life prediction formula from both the time series change in the case where no load is applied to the secondary battery and the time series change in the case where a load is applied to the secondary battery.

In addition, in the embodiment described above, the case where the secondary battery deterioration prediction system 10 includes one computer is described as an example, and a deterioration prediction system similar to the system may include a plurality of computers. For example, some data such as data obtained by measuring the positive electrode and the negative electrode of the secondary battery may be held in a server connected to the secondary battery deterioration prediction system 10 via a network, and the secondary battery deterioration prediction system 10 may exchange information with the server to execute similar processing. In addition, a part of the configuration included in the calculator 12 illustrated in FIG. 2 may be arranged in the other computer and processed by the other computer.

In addition, in the configuration diagrams illustrated in FIGS. 1 and 2, control lines and information lines exemplify only what is considered to be necessary for the description and do not necessarily exemplify all the control lines and the information lines on a product. In practice, it may be considered that almost all of the configurations are connected to each other.

In addition, a flow of processes illustrated in the flowchart in FIG. 7 is also an example, and if the same processing results are obtained, a processing order may be partially changed, or a plurality of processes may be executed simultaneously.

In addition, in a case where the secondary battery deterioration prediction system described in the present embodiment includes an information processing apparatus such as the computer, programs for implementing respective processing functions may be prepared in a nonvolatile storage or a memory in a computer apparatus, or may be stored in a recording medium such as an external memory, an IC card, an SD card, or an optical disk and transferred.

Reference Signs List

| | |
|---|---|
| 1 | CPU |
| 2 | memory |
| 3 | storage |
| 4 | input device |
| 5 | network interface |
| 6 | output unit |
| 10 | secondary battery deterioration prediction system |
| 11 | input unit |
| 12 | calculator |
| 13 | output unit |
| 121 | positive electrode information and negative electrode information acquisition unit |
| 122 | battery information acquisition unit |
| 123 | internal state diagnosis unit |
| 124 | time series change formula generation unit |
| 125 | functionalization unit |
| 126 | life prediction formula generation unit |
| 127 | deterioration calculation unit |

**Claims**

**1.** A secondary battery deterioration prediction system comprising:

an acquisition unit that acquires, in each operation condition of a secondary battery, a relationship between a charging status and an open circuit voltage of the secondary battery and a relationship between the charging status and an internal resistance of the battery;

an internal state diagnosis unit that diagnoses, based on the relationships acquired by the acquisition unit, a deterioration state of a positive electrode and a negative electrode of the secondary battery in each operation condition;

a life prediction formula generation unit that generates a life prediction formula for predicting a life of the secondary battery based on a time series change in the deterioration state obtained by the internal state diagnosis unit; and

a deterioration calculation unit that calculates deterioration of the secondary battery based on the life prediction formula generated by the life prediction formula generation unit, wherein

the life prediction formula generation unit generates a life prediction formula based on a time series change in a deterioration state of the positive electrode and the negative electrode in a case where a load is applied to the secondary battery.

2. The secondary battery deterioration prediction system according to claim 1, wherein
the life prediction formula generation unit further generates a life prediction formula based on a time series change in a deterioration state of the positive electrode and the negative electrode in a case where no load is applied to the secondary battery.

3. The secondary battery deterioration prediction system according to claim 2, wherein

the internal state diagnosis unit diagnoses a deterioration state of the positive electrode and the negative electrode using

a relationship group between charging statuses and open circuit potentials and a relationship group between the charging statuses and internal resistances unique to a positive electrode active material of the secondary battery, and

a relationship group between charging statuses and open circuit potentials and a relationship group between the charging statuses and internal resistances unique to a negative electrode active material of the secondary battery.

4. The secondary battery deterioration prediction system according to claim 3, comprising

a time series change formula generation unit that generates a time series change formula of a state diagnosed by the internal state diagnosis unit, wherein

the life prediction formula generation unit generates a life prediction formula based on the time series change formula generated by the time series change formula generation unit.

5. The secondary battery deterioration prediction system according to claim 4, wherein

when a deterioration state of the positive electrode and the negative electrode is diagnosed,

the internal state diagnosis unit further extracts at least one parameter of an active material utilization of the positive electrode, an active material utilization of the negative electrode, a lithium ion loss associated with film formation on a positive electrode surface, a lithium ion loss associated with film formation on a negative electrode surface, a solution resistance of the battery, a resistance increase rate of the positive electrode, and a resistance increase rate of the negative electrode.

6. The secondary battery deterioration prediction system according to claim 5, wherein
the time series change formula generation unit generates a time series change formula based on time series changes in the parameter extracted extracted by the internal state diagnosis unit.

7. The secondary battery deterioration prediction system according to claim 2, wherein

the internal state diagnosis unit further diagnoses deterioration of the secondary battery due to a storage load and deterioration of the secondary battery due to an operation load, and

the life prediction formula generation unit generates a battery life prediction formula by combining the deterioration due to the storage load and the deterioration due to the operation load.

8. The secondary battery deterioration prediction system according to claim 2, wherein
the deterioration calculation unit calculates and outputs time series changes in capacity and resistance of the secondary battery based on an operation condition of the secondary battery.

EP 4 726 414 A1

9. A secondary battery deterioration prediction method comprising:

an acquiring process of acquiring, in each operation condition of a secondary battery, a relationship between a charging status and an open circuit voltage of the secondary battery and a relationship between the charging status and an internal resistance of the battery;
an internal state diagnosing process of diagnosing, based on the relationships acquired by the acquiring process, a deterioration state of a positive electrode and a negative electrode of the secondary battery in each operation condition;
a life prediction formula generating process of generating a life prediction formula for predicting a life of the secondary battery based on a time series change in the deterioration state obtained by the internal state diagnosing process; and
a deterioration calculating process of calculating deterioration of the secondary battery based on the life prediction formula generated by the life prediction formula generating process, wherein
the life prediction formula generated in the life prediction formula generating process is generated based on a time series change in a deterioration state of the positive electrode and the negative electrode in a case where a load is applied to the secondary battery.

[FIG. 1]

## FIG. 1

[FIG. 2]

*FIG. 2*

12

121

POSITIVE ELECTRODE INFORMATION AND NEGATIVE ELECTRODE INFORMATION ACQUISITION UNIT

122

BATTERY INFORMATION ACQUISITION UNIT

123

INTERNAL STATE DIAGNOSIS UNIT

124

TIME SERIES CHANGE FORMULA GENERATION UNIT

FUNCTIONALIZATION UNIT

125

LIFE PREDICTION FORMULA GENERATION UNIT

126

DETERIORATION CALCULATION UNIT

127

[FIG. 3]

## FIG. 3

[FIG. 4]

## FIG. 4

[FIG. 5]

*FIG. 5*   $m_n$

TIME [day]

[FIG. 6]

*FIG. 6*   $\delta_n$

TIME [day]

[FIG. 7]

*FIG. 7*

```
                    ┌──────────────┐
                    │    START     │
                    └──────┬───────┘
                           │
                           ▼
        ┌───────────────────────────────────────┐
        │ ACQUIRE OPEN CIRCUIT POTENTIAL AND     │
        │ RESISTANCE INFORMATION OF POSITIVE     │──S11
        │ ELECTRODE AND NEGATIVE ELECTRODE       │
        └───────────────────┬───────────────────┘
                            │
                            ▼
        ┌───────────────────────────────────────┐
        │ ACQUIRE OPEN CIRCUIT VOLTAGE INFORMATION│──S12
        │ AND RESISTANCE INFORMATION OF BATTERY  │
        └───────────────────┬───────────────────┘
                            │
                            ▼
        ┌───────────────────────────────────────┐
        │ DIAGNOSE INTERNAL STATE OF BATTERY     │──S13
        └───────────────────┬───────────────────┘
                            │
                            ▼
        ┌───────────────────────────────────────┐
        │ GENERATE TIME SERIES CHANGE FORMULA    │──S14
        │ OF EACH DETERIORATION PARAMETER        │
        └───────────────────┬───────────────────┘
                            │
                            ▼
        ┌───────────────────────────────────────┐
        │ FUNCTIONALIZE TIME SERIES CHANGE FORMULA│
        │ OF EACH DETERIORATION PARAMETER         │──S15
        │ ACCORDING TO OPERATION CONDITION        │
        └───────────────────┬───────────────────┘
                            │
                            ▼
        ┌───────────────────────────────────────┐
        │ GENERATE BATTERY LIFE PREDICTION FORMULA│──S16
        └───────────────────┬───────────────────┘
                            │
                            ▼
        ┌───────────────────────────────────────┐
        │ CALCULATE DETERIORATION                │──S17
        │ BY PREDICTION FORMULA                  │
        └───────────────────┬───────────────────┘
                            │
                            ▼
                    ┌──────────────┐
                    │     END      │
                    └──────────────┘
```

## INTERNATIONAL SEARCH REPORT

| | International application No. |
|---|---|
| | **PCT/JP2024/008352** |

### A. CLASSIFICATION OF SUBJECT MATTER

*G01R 31/392*(2019.01)i; *G01R 31/367*(2019.01)i; *G01R 31/382*(2019.01)i; *G01R 31/389*(2019.01)i; *H01M 10/48*(2006.01)i
FI:   G01R31/392; G01R31/367; G01R31/389; G01R31/382; H01M10/48 P

According to International Patent Classification (IPC) or to both national classification and IPC

### B. FIELDS SEARCHED

Minimum documentation searched (classification system followed by classification symbols)

G01R31/392; G01R31/367; G01R31/382; G01R31/389; H01M10/48

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2018/003210 A1 (HITACHI, LTD.) 04 January 2018 (2018-01-04) paragraphs [0009]-[0108], fig. 1-18 | 1-6, 8-9 |
| A | | 7 |
| A | JP 2023-77830 A (HITACHI, LTD.) 06 June 2023 (2023-06-06) entire text, all drawings | 1-9 |
| A | JP 2016-82728 A (HITACHI, LTD.) 16 May 2016 (2016-05-16) entire text, all drawings | 1-9 |
| A | JP 2021-39939 A (GS YUASA INTERNATIONAL LTD.) 11 March 2021 (2021-03-11) entire text, all drawings | 1-9 |

☐ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **02 May 2024** | **14 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

| Patent document cited in search report | | | Publication date (day/month/year) | Patent family member(s) | | | Publication date (day/month/year) |
|---|---|---|---|---|---|---|---|
| WO | 2018/003210 | A1 | 04 January 2018 | (Family: none) | | | |
| JP | 2023-77830 | A | 06 June 2023 | WO | 2023/095500 | A1 | |
| JP | 2016-82728 | A | 16 May 2016 | US | 2016/0118816 | A1 | |
| | | | | entire text, all drawings | | | |
| JP | 2021-39939 | A | 11 March 2021 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009080093 A